# EUROPÄISCHE PATENTANMELDUNG

(11) **EP 0 700 075 A2**
(43) Veröffentlichungstag der Anmeldung: **06.03.1996**
(21) Anmeldenummer: 95101313.5
(22) Anmeldetag: 31.01.1995
(51) Int. Cl.: H01L 21/00, B65G 49/07

(54) **Einrichtung zur Umsetzung eines Transportobjektes zwischen zwei Endlagen**

(30) Priorität: 31.08.1994 DE 4430846
(71) Anmelder: JENOPTIK Technologie GmbH, D-07745 Jena (DE)
(72) Erfinder: Scheler, Werner, D-07743 Jena (DE); Gräfe, Jürgen, D-07745 Jena (DE); Mages, Andreas, D-07745 Jena (DE); Birkner, Andreas, D-07743 Jena (DE); Adler, Erich, D-07747 Jena (DE)
(74) Vertreter: Geyer, Werner

(57) **Zusammenfassung**

Bei einer Einrichtung zur Umsetzung eines Transportobjektes zwischen zwei Endlagen besteht die Aufgabe, auch bei verlängerten Transportwegen sich auf die Zuverlässigkeit und die Reinstraumbedingungen negativ auswirkende Einflüsse bei Gewährleistung einer hohen Flexibilität bei der Umsetzung auszuschließen.

Gemäß der Erfindung erfolgt zur Steuerung der Funktionen von Sensoren und Aktoren an einem zur Umsetzung dienenden beweglichen Teil eines Antriebes eine elektrische Kontaktierung dieser Sensoren und Aktoren mit einer Versorgungseinheit (10), die sich in einem feststehenden Teil des Antriebes (7, 41) befindet, ausschließlich in den beiden Endlagen.

Die Einrichtung gemäß der Erfindung ist insbesondere zum Einsatz in der Halbleiterfertigung, z. B. zur Beschickung von Halbleiterbearbeitungsmaschinen vorgesehen, jedoch nicht auf dieses Gebiet beschränkt.

## Beschreibung

Die Erfindung betritt eine Einrichtung zur Umsetzung eines Transportobjektes zwischen zwei Endlagen, bei der ein feststehendes Teil ein zwischen den Endlagen durch einen Antrieb linear bewegliches Teil trägt, wobei das feststehende Teil eine Versorgungseinheit zur Signal- und Motorstromversorgung von Sensoren und Aktoren am beweglichen Teil enthält.

Bei der Herstellung integrierter Schaltkreise müssen Halbleiterscheiben zwischen unterschiedlichen Bearbeitungsschritten zu einzelnen Bearbeitungsmaschinen transportiert werden. In zunehmendem Maße geschieht dies in standardisierten Transportbehältern sogenannten Standard Mechanical Interface Boxen (SMIF-Boxen), da anstelle der Optimierung konventioneller Reinräume in Richtung höherer Reinheitsklassen zur Erzielung größerer Integrationsdichten die konsequente Durchsetzung des Einsatzes von Einhausungen oder der Einsatz der SMIF-Technologie in den Halbleiterbearbeitungsanlagen einen Weg darstellt, um höhere Ausbeuten zu vertretbaren Kosten zu erreichen.
Die Halbleiterscheiben sind in Fächer eines Magazins eingeschoben, das auf dem Boden der SIMF-Box in geeigneter Weise fixiert ist.

Zur Beschickung der Halbleiterbearbeitungsanlagen erfolgt zunächst eine Entnahme der Magazine aus den Transportbehältern. Danach ist in der Regel eine Umsetzung notwendig, zu deren Durchführung verschiedene technische Lösungen bekannt geworden sind.
So wird nach EP 209 660 eine Kassette durch einen automatisierten Kassettenmanipulator von einem SMIF-Fahrstuhl zu einem Gerätefahrstuhl transportiert, indem eine Schwenkbewegung während der senkrechten Auf- oder Abbewegung der Kassette eingesetzt wird. Durch den Einsatz von Drehelementen soll das Maß der Partikelerzeugung gegenüber linear sich bewegenden Elementen herabgesetzt werden.
Ähnliche Lösungen sind auch in EP 238 541 beschrieben, bei denen das Umsetzen des Magazins über vorgegebene Bewegungskurven durch den Einsatz motorisch angetriebener Hebelarme erfolgt, die mit einem seperaten Lift in z-Richtung verfahren werden.

Durch die mechanische Ausführung der bekannten Lösungen, insbesondere den seitlich am Magazin vorbeigeführten Wirkbereich des als Hebelarm ausgebildeten Umsetzers bzw. den geschlossenen Aufbau wird die zum Erhalt des Reinstraumes erforderliche Laminarluftströmung stark gestört oder verhindert.
Die Kopplung der Umsetzbewegung mit der z-Bewegung verlängert unnötig die Transportzeiten und erhöht die Partikelgenerierung.
Außerdem ist es mit den bekannten Lösungen schwierig bei der Nachrüstung von Halbleiterbearbeitungsanlagen bereits bestehende Reinsträume mit dem SMIF-System zu komplettieren, so daß Wafermagazine unter SMIF-Bedingungen in die Maschinen eingebracht und dort unter Reinstraumbedingungen entpackt und transportiert werden können.

Nach der DE-Patentschrift 43 26 309 C1 ist eine technische Lösung bekannt, bei der zur Umsetzung des Magazins von einer Abstellposition zu einem Bearbeitungplatz an einer tragenden Säule ein in Fahrtrichtung des Fahrstuhles höhenverstellbarer Linearantrieb für einen starten Greiferarm befestigt ist. Der Aktionsbereich des Greiferarmes liegt oberhalb des sich in der Abstellposition befindlichen Magazins und ist senkrecht zur Fahrtrichtung des Fahrstuhles gerichtet. Zwischen der tragende Säule und einem Fahrstuhlantrieb ist eine Luftdurchtrittsöffnung vorgesehen. Alle Antriebsteile sind durch eine staubdichte Kapselung vom Reinstraum getrennt, und an Öffnungen, durch die Transportelemente in den Reinstraum ragen, grenzen Absaugeinrichtungen an.

Zwar werden die vorstehend genannten Nachteile beseitigt, doch können bei länger werdenden Transportwegen mitgeführte Kabel für die Signal- und Motorstromübertragung von dafür vorgesehenen Einrichtungen im feststehenden Teil der Vorrichtung auf bewegliche Teile zu Störungen führen und die Zuverlässigkeit negativ beeinflussen. Von Nachteil ist außerdem die mechanische Rückwirkung der Kabelverbindung auf die beweglichen Teile und die Möglichkeit einer Partikelgenerierung.
Außerdem erfordern die Halbleiterbearbeitungsanlagen in ihrer Vielfalt auch unterschiedliche Beschickungs- und Abstellvarianten für die Magazine.

Desweiteren haben pneumatisch betriebene Linearantriebe den Nachteil, in Endlagen beidseitig des Zylinders auf sehr dem Weg durch eine Geschwindigkeitssteuerung mittels Drosselrückschlagventilen in Form einer Endlagendämpfung abzubremsen. Dabei wird von der maximalen Geschwindigkeit auf einem Weg von wenigen Millimetern auf Null abgebremst. Es entstehen unvermeidbare Stöße auf das Transportobjekt.

Aufgabe der Erfindung ist es deshalb, auch bei verlängerten Transportwegen sich auf die Zuverlässigkeit und die Reinstraumbedingungen negativ auswirkende Einflüsse bei Gewährleistung einer hohen Flexibilität bei der Umsetzung auszuschließen.

Die Aufgabe wird durch eine Einrichtung zur Umsetzung eines Transportobjektes zwischen zwei Endlagen gelöst, bei der ein feststehendes Teil, ein zwischen den Endlagen durch einen Antrieb linear bewegliches Teil trägt, wobei das feststehende Teil eine Versorgungseinheit zur Signal- und Motorstromversorgung von Sensoren und Aktoren am beweglichen Teil enthält, indem zur
Steuerung der Funktionen der Sensoren und Aktoren eine elektrische Kontaktierung der Sensoren und Aktoren mit der Versorgungseinheit ausschließlich in den beiden Endlagen erfolgt.

Zur elektrischen Kontaktierung sind vorteilhafterweise Baugruppen mit federnden Kontakten vorgesehen, von denen das feststehende Teil in den Endlagen des beweglichen Teiles jeweils eine Baugruppe und das bewegliche Teil mindestens eine weitere Baugruppe trägt, wobei die federnden Kontakte am feststehenden Teil, die elektrisch mit der Versorgungseinheit verbunden sind, den federnden Kontakten am beweglichen Teil, von denen elektrische Verbindungen zu den Sensoren und Aktoren bestehen, zugewandt sind.
Die federnden Kontakte sollten als Goldkontakte ausgebildet sein, in Form von federnd in einer Hülse gehaltenen Goldstiften.

Durch den Ersatz von sonst üblicherweise notwendigen mitgeführten Spiralkabeln durch diese Kontaktgruppen und die Herstellung einer elektrischen Kontaktierung nur in den Enlagen wird die Zuverlässigkeit der Einrichtung wesentlich erhöht, da Kabelbrüche, die infolge der starken mechanischen Beanspruchung der mitgeführten Kabel auftreten können, ausgeschlossen werden. Positiv wirkt sich auch aus, daß durch diesen Ersatz eine weitere Quelle der Partikelgenerierung ausgeschaltet ist.

Zur vertikalen Umsetzung des Transportobjektes von einer oberen Entnahme- und Rückführungsposition in eine untere Abstellposition dient eine mit Sensoren und Aktoren versehene Platte, die von einem beweglichen Teil eines Fahrstuhles aufgenommen ist.

Die Sensoren und Aktoren können auch Bestandteile eines Greifer sein, mit dem die Umsetzung des Transportobjektes im wesentlichen horizontal erfolgt.
Für diesen Fall ist es von Vorteil, wenn zumindest in einem Abschnitt der Bewegung des beweglichen Teiles mit der Linearbewegung eine rotatorische Bewegung des Greifers verbunden ist.

Dazu besteht zwischen dem Greifer und einem Greiferarm, an dem der Greifer drehbar befestigt ist und der die Verbindung zu dem Antrieb herstellt, eine mechanische Kopplung, die die Linearbewegung des Greifers mit der rotatorischen Bewegung des Greifers verknüpft.

In einer ersten Ausführung weist die drehbare Befestigung des Greifers am Greiferarm eine parallel zur Ebene der Linearbewegung und senkrecht zur Linearbewegung selbst gerichtete Drehachse auf.

Zur mechanischen Kopplung der rotatorischen Bewegung des Greifers mit der Linearbewegung ist ein mit dem Greiferarm verbundener erster Hebel vorgesehen, der während der Linearbewegung eine Kulisse, die eine Höhendifferenz aufweist, abtastet, und der über eine drehbar befestigte Schubstange mit einem am Greifer befestigten zweiten Hebel zur Übertragung der Höhendifferenz und Umformung in die rotatorische Bewegung verbunden ist.

Vorteilhaft ist es, wenn der erste Hebel zur Einstellung des Drehwinkels des Greifers in seiner wirksamen Hebellänge einstellbar ist.

In einer zweiten Ausführung weist die drehbare Befestigung des Greifers am Greiferarm eine senkrecht zur Ebene der Linearbewegung gerichtete Drehachse auf.

Zur mechanischen Kopplung der rotatorischen Bewegung des Greifers mit der Linearbewegung sind an einer in Kugelumlaufführungen geführten und gelagerten Zugstange ein Mitnehmer für eine am Greifer in einer außermittig angeordneten Kugelgelenkverbindung gelagerte Koppelstange und ein erster Anschlag befestigt, der bei vorwärtiger Linearbewegung des Greiferarms durch seine Anlage an einem zweiten Anschlag am festen Teil ein Zurückbleiben der Zugstange und des Mitnehmers verursacht.

Es ist von Vorteil, wenn die Kugelgelenkverbindung ein federkraftbeaufschlagtes, justierbares Anschlagsystem aufweist.

Ferner ist es von Vorteil, wenn zur Erzeugung der Linearbewegung des Greifers ein pneumatischer Linearantrieb vorgesehen ist.
Zur Geschwindigkeitssteuerung für jede Richtung der Linearbewegung ist am Zylinder des pneumatischen Linearantriebes mindestens ein Paar von parallel wirkenden Drosseln mit voneinander verschieden einstellbaren Luftdurchlaßmengen vorgesehen, und die Zahl der in Richtung der Linearbewegung wirksam werdenden Drosseln ist in Abhängigkeit vom Ort des beweglichen Teiles und der Richtung der Linearbewegung von Sensorsignalen gesteuert.

Als Drosseln sind vorteilhafterweise Drosselrückschlagventile vorgesehen, die die Drosselung von Abluft einstellbar zulassen und Luft in Bewegungsrichtung ungehindert durchlassen.

Die Erfindung soll nachstehend anhand der schematischen Zeichnung näher erläutert werden. Es zeigen:
- Fig. 1: eine Ansicht einer Beschickungseinrichtung zur Drehung eines Magazin in eine "Rückenlage" mit beweglichem Teil in einer Endlage
- Fig. 2: die Beschickungseinrichtung gemäß Fig. 1 mit beweglichem Teil in der anderen Endlage
- Fig. 3: in vergrößerter Darstellung die mechanische Kopplung der Drehbewegung in die "Rückenlage" an die Linearbewegung
- Fig. 4: in Blockdarstellung die Geschwindigkeitssteuerung des Antriebes
- Fig. 5: eine Ansicht einer Bechickungseinrichtung zur Drehung eines Magazins um eine senkrecht zur Ebene der Linear bewegung gerichtete Achse mit beweglichem Teil in einer Endlage
- Fig. 6: die Beschickungseinrichtung gemäß Fig. 5 mit beweglichem Teil in der anderen Endlage

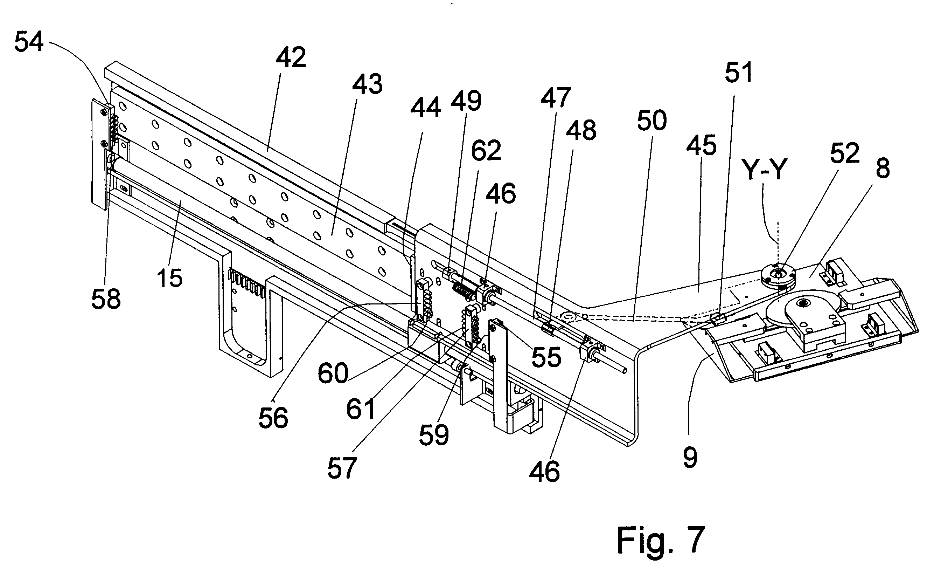

- Fig. 7: in vergrößerter Darstellung die mechanische Kopplung der Drehbewegung um eine senkrecht zur Ebene der Linearbewegung gerichtete Achse an die Linearbewegung

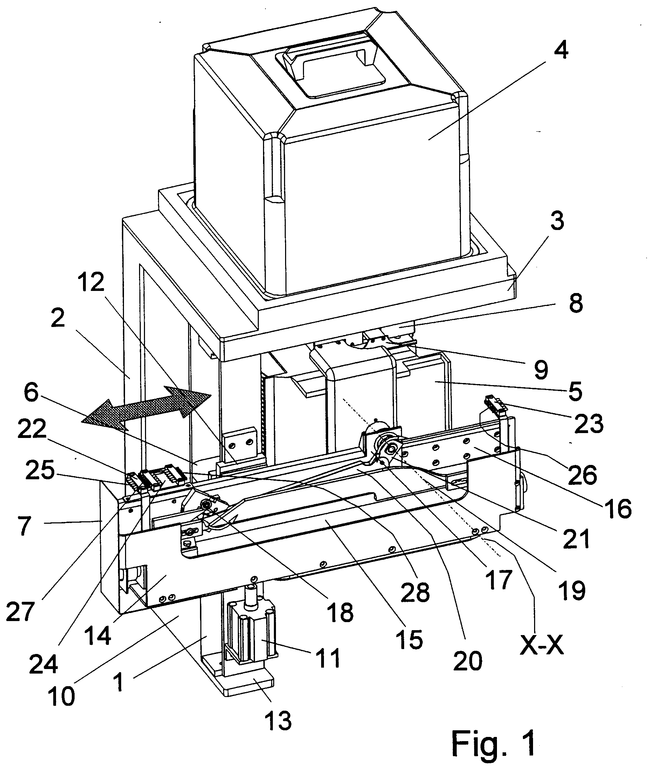

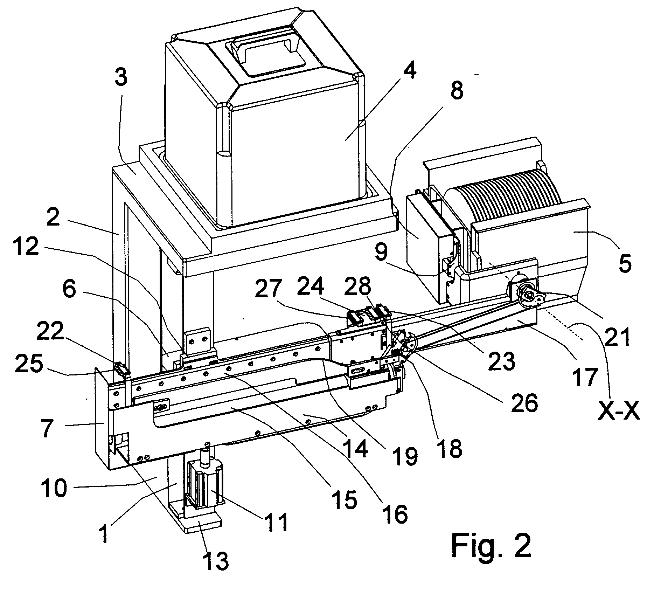

In den Figuren 1 und 2 dienen eine tragende Säule 1 und ein verkleideter Fährstuhlantrieb 2, deren Abstand zueinander eine Luftdurchtrittsöffnung darstellt, als Abstützelemente für eine Aufnahme 3, auf die ein Magazinbehälter 4 abgestellt ist. Ein durch den Fahrstuhlantrieb 2 in z-Richtung verfahrbarer, in der DE-Patentschrift 43 26 309 C1näher beschriebener Fahrstuhl mit einem Aufnahmearm ist vorgesehen, um die Entnahme und Rückführung eines in dem Magazinbehälter 4 befindlichen Magazins 5 für waferartige Objekte auszuführen.
In den vorliegenden Darstellungen ist das Magazin 5 aus dem Magazinbehälter 4 zusammen mit dessen Boden entnommen und steht auf einer aus der Aufnahme 3 heraus absenkbaren Platte 6, die für die SMIF-Technologie notwendige Aktoren und Sensoren enthält. So ist es z. B. erforderlich, den Zustand zu erfassen, ob ein Magazinbehälter 4 abgestellt ist oder nicht oder ob dieser geöffnet oder geschlossen ist.
Der Fahrstuhl besitzt einen beweglichen Teil, der in einem feststehenden Teil geführt, zwischen einer oberen Entnahme- und Rückführungsposition und einer unteren Abstellposition verfahrbar ist. Die obere Entnahme- und Rückführungsposition und die untere Abstellposition entsprechen jeweils einer ersten und einer zweiten Endlage des beweglichen Teiles des Fahrstuhles.
An der tragenden Säule 1 ist ein Linearantrieb 7 für einen beweglichen Greifer 8 befestigt, dessen Aktionsbereich oberhalb des sich in der unteren Abstellposition befindlichen Magazins 5 liegt und senkrecht zur Fahrtrichtung des Fahrstuhlantriebes 2 gerichtet ist.
Der Greifarm 8 ist mit den greifenden Elementen 9 und hier nicht dargestellten Sensoren zur Überwachung des Greifvorganges versehen.
Im unteren Bereich zwischen der Säule 1 und den Fahrstuhlantrieb 2 ist eine Versorgungseinheit 10 zur Signal- und Motorstromversorgung für den Linearantrieb 7, den Greifer 8 mit seinen greifenden Elementen 9 und einem zur z-Verstellung dienenden pneumatischen Kurzhubzylinder 11 mit einer Wälzführung 12 untergebracht.
Mit einer Grundplatte 13 ist die gesamte Einrichtung über ein mechanisches Interface an einer Halbleiterbearbeitungsanlage befestigbar.
Zur Erzeugung des mit einem Pfeil gekennzeichneten Luftstromes kann zwischen der Säule 1 und dem Fahrstuhlantrieb 2 eine Absaugvorrichtung oder eine Filter/Lüfter-Einheit angebracht werden, deren Drehzahl regelbar sein kann.
Im Bereich der Aufnahme 3 sind Bedien- und Anzeigeelemente untergebracht. Eine externe Steuerelektronik besitzt eine Kabelverbindung zu der Einrichtung, die aus einzelnen Modulen besteht, die durch unterschiedliche Kombinationen zu verschiedendsten Anlagen mit unterschiedlichsten Bewegungsabläufen montiert werden können. Es ist auch möglich, falls erforderlich, daß nur einzelne Bewegungsabläufe, wie z. B. die vertikale Bewegung des Fahrstuhles realisiert sind.

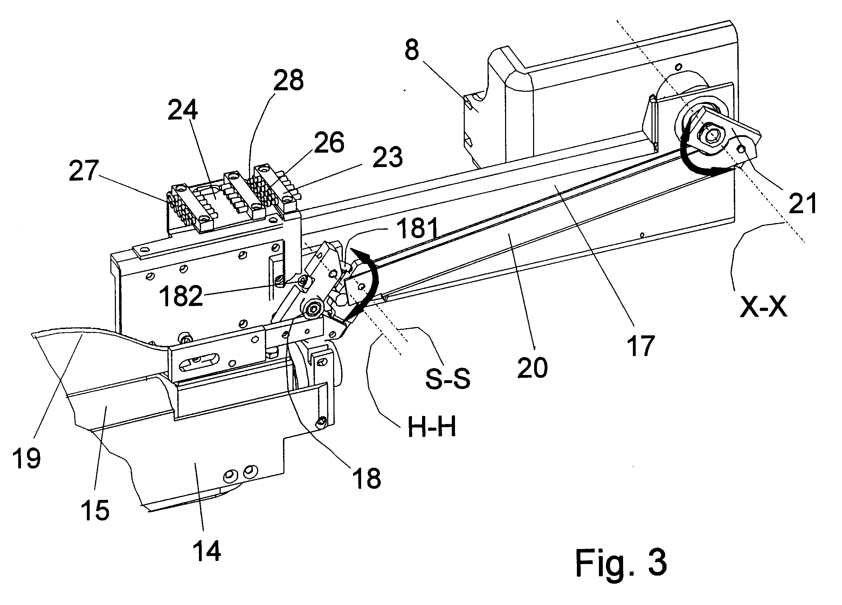

In dem Linearantrieb 7 nimmt eine tragende Grundplatte 14 einen pneumatischen Linearzylinder 15 mit einem innenliegenden beweglichen Kolben und eine zu diesem parallel angeordnete Wälzführung 16 auf. Der Linearzylinder 15 und die Wälzführung 16 sind über einen Greiferarm 17 als beweglichen Teil miteinander verbunden, an dem der Greifer 8 in einem einstellbaren Winkelbereich um eine parallel zur Ebene der Linearbewegung und senkrecht zur Linearbewegung selbst gerichtete Achse X-X drehbar befestigt ist.
Zur Drehung des Greifers 8 um die Achse X-X ist, wie die vergrößerte Darstellung in Fig. 3 zeigt, ein um eine Achse H-H drehbarer erster Hebel 18 vorgesehen, der während der Linearbewegung eine Kulisse 19 abtastet. Die Kulisse 19 weist eine Höhendifferenz auf, die durch eine an dem ersten Hebel 18 um eine Achse S-S drehbar befestigte Schubstange 20 auf einen zweiten Hebel 21 übertragen wird, der wiederum die Verbindung zwischen der Schubstange 20 und den Greifer 8 herstellt. Der erste Hebel 18 ist so konstruiert, daß seine wirksame Hebellänge und damit der Drehwinkel des Greifers 8 einstellbar ist. Über einen Einstellstift 181 wird der Abstand zwischen der Drehachse H-H des Hebels 18 und dem in der Achse S-S liegenden Eingriffspunkt der als Koppel dienenden Schubstange 20 verändert und mit einer Klemmschraube 182 fixiert.
Durch eine nicht sichtbare Zugfeder wird erreicht, daß der erste Hebel 18 immer an der Kulisse 19 anliegt und somit der Drehwinkel des gekippten Greifers 8 erhalten bleibt.

Nach Fig. 1 wird das Magazin 5, das dem Magazinbehälter entnommen ist und sich in der unteren Abstellposition befindet, von dem Greifer 8 mittels seiner motorisch bewegten greifenden Elemente 9 erfaßt, durch eine pneumatische Hubbewegung, erzeugt durch den Kurzhubzylinder 11, angehoben und durch den Linearantrieb 7 von einer ersten in eine zweite Endlage des beweglichen Teiles des Linearantriebes 7 (Magazinplatz der Halbleiterbearbeitungsanlage) transportiert.
Kurz vor Erreichen der zweiten Endlage erfolgt durch die Übertragung der Höhendifferenze H der Kulisse 19 auf den zweiten Hebelarm 21 eine Drehung des Greifers 8 und damit des Magazins 5 um die Achse X-X, so daß die vorher im Magazin 5 nach vom entnehmbaren Halbleiterscheiben nun nach oben zeigen und so entnehmbar sind.
Die Drehung ist nach einem in der Länge bestimmten Linearweg beendet und die Endlage wird eingenommen. Es erfolgt über den Kurzhubzylinder 11 eine Absenkung und das Magazin 5 wird fixiert abgelegt.
Der Greifer 8 koppelt vom Magazin 5 ab und wird angehoben in seine Ruhestellung zurückgefahren. Der Fahrstuhlantrieb 2 hat den beweglichen Teil des Fahrstuhles vorher zusammen mit der Platte 6 und dem Boden des Magazinbehälters 4 wieder nach oben in seine erste Endlage gefahren, so daß der Magazinbehälter 4 geschlossen und somit zum Magazinwechsel freigegebenen ist.
Nach dem Einbringen eines Magazins in die Halbleiterbearbeitungsanlage kann diese die Schließung einer eventuell vorhandenen Schleusentür in ihrem Magazinbewegungsraum veranlassen, oder es werden weitere Magazine in die Halbleiterbearbeitungsanlage eingebracht.
Das Heraustransportieren der Magazine aus der Halbleiterbearbeitungsanlage erfolgt in umgekehrter Reihenfolge

Zur Signal- und Motorstromübertragung von der Versorgungseinheit 10 zu Aktoren und Sensoren des Greifers 8 dienen Baugruppen 22, 23 und 24, von denen am feststehenden Teil in den Endlagen des beweglichen Teiles die Baugruppen 22 und 23 ortsfest montiert ist. Die Baugruppe 24 ist am Greiferarm 17 befestigt. Die Baugruppen 22, 23 weisen federnde Kontakte 25, 26 auf, die federnden Kontakten 27, 28 an der Baugruppe 24 zugewandt sind.
Von den federnden Kontakten 25, 26, die als Goldkontakte ausgebildet sind, in Form von federnd in einer Hülse gehaltenen Goldstiften, bestehen elektrische Verbindungen zur Versorgungseinheit 10 und von den Kontakten 27, 28 zu den Sensoren und Aktoren des Greifers 8.
Befindet sich der Greifer in der Endlage gemäß Fig. 1, berühren sich die die Kontakte 25 und 27 und in der Endlage gemäß Fig. 2 die Kontakte 26 und 28 und ermöglichen die Signal- und Motorstromübertragung.
Die Goldstifte der Kontakte 27, 28 am beweglichen Teil setzen mit möglichst großem Druck auf ihr Gegenstück am feststehenden Teil auf, um einen kleinen Übergangswiderstand zu erreichen. Der erforderliche Kontaktdruck wird über die Federer zeugt.
Der Arbeitshub, der durch die Federung erreicht wird, bewirkt, daß vor dem Verlassen der Endlagen noch kurzzeitiger elektrischer Kontakt besteht.
Während der Linearbewegung bzw. Drehung des Greifers 8 ist dessen elektrische Versorgung unterbrochen. Nur in den Endlagen ist die Versorgung des Greifers 8 gewährleiset, so daß ein Magazin übernommen bzw. übergeben werden.

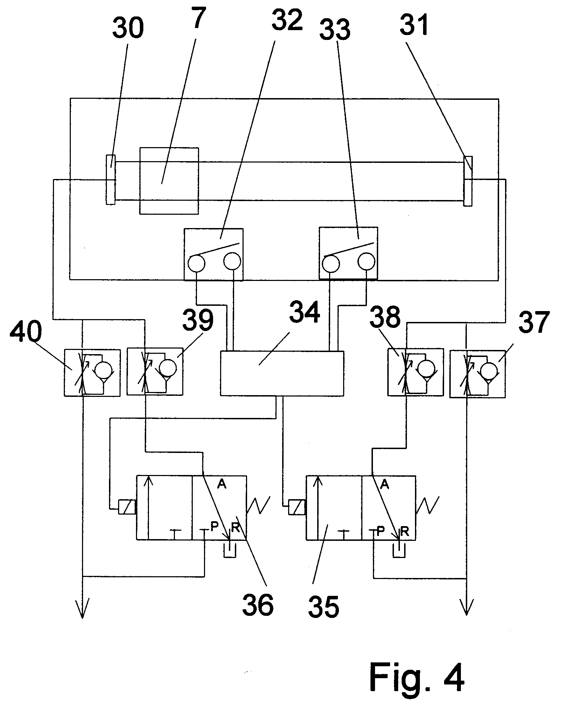

Zur Steuerung der Geschwindigkeit des pneumatischen Antriebes 7 sieht Fig. 4 eine Lösung vor, bei der entlang des Fahrweges des Kolbens zwei parallel zur Linearbewegung angeordnete und zu Endlagen 30, 31, die als feste Anschläge ausgebildet sind, justierbare Sensoren 32, 33 vor, die durch ein mit dem Kolben verbundenes Auslöseteil betätigt werden.
Von den Sensoren 32, 33 bestehen elektrische Verbindungen zu einer Elektronik 34, die die Impulssignale der Sensoren 32, 33 unter Beachtung der Fahrtrichtung in Signale zur Ansteuerung pneumatischer Ventile 35, 36 umwandelt. Mit jedem der pneumatischen Ventile 35, 36 ist ein Paar von Drosselrückschlagventilen 37, 38 und 39, 40 verbunden, die in der Abluftleitung des Zylinders angeordnet sind.
Bei einer Bewegung von der Endlage 30 in die Endlage 31 wird zunächst durch den Sensor 32 das Ventil 35 geöffnet, wodurch das Drosselrückschlagventil 38 dem Drosselrückschlagventil 37 zugeschaltet wird. Entsprechend der inneren Reibung des Antriebes und der Einstellung der Drosselrückschlagventile 37, 38 ergibt sich eine relativ hohe Endgeschwindigkeit des Kolbens. Erfolgt die Bewegung über den Sensor 33 hinausgehend, wird das Ventil 35 geschlossen und damit das Drosselrückschlagventil 38 abgeschaltet. In Folge verringert sich die Geschwindigkeit des Kolbens bis zur Endlage 31 fast sinusförmig auf Null. Es wird ein sanftes Anfahren der Endlage 31 erreicht. Eine Erschütterung oder Bewegung der im Magazin zu transportierenden Wafer wird vermieden.
Ohne Einfluß bleibt vorerst ein mit dem Überfahren des Sensors 33 verbundenes Einschalten des Ventils 36. Erst bei umgekehrter Fahrtrichtung von der Endlage 31 zur Endlage 30 wird das durch die Einschaltung des Ventils 36 geöffnete Drosselrückschlagventil 39 wirksam, und es erfolgt ein Bewegungsablauf wie für die entgegengesetzte Richtung bereits beschrieben. Das bei Betätigung des Sensor 32 ausgelöste Signal schließt das Ventil 36 und der Kolben verringert infolge der Abschaltung des Drosselrückschlagventils 39 seine Geschwindigkeit und wird durch die Wirkung des Drosselrückschlagventils 40 bis zur Endlage 30 auf Null abgebremst.
In ähnlicher Weise wie schon bei der Fahrt von der Endlage 30 zur Endlage 31 hat ein erneutes, mit der Betätigung des Sensors 32 verbundene Öffnen des Ventils 35 vorerst keine Wirkung. Bei der Fahrt in entgegengesetzter Richtung wird dann das betätigte Drosselrückschlagventil 38 wirksam.
Durch die Festigung des Abstandes der Sensoren 32, 33 von den Endlagen 30, 31 und die Einstellung der beiden jeweils zusammengehörenden Drosselrückschlagventile 37 und 38 bzw. 39 und 40 sind die erreichbaren Endgeschwindigkeiten bestimmbar.
Im vorliegenden Ausführungsbeispiel werden bei Abständen Endlage - Sensor von 90 ... 120 mm Geschwindigkeiten des Kolbens von 100 ... 150 mm/s realisiert.
Als Ventile werden 2/2-Wegeventile oder 3/2-Wegeventile mit einem verschlossenen Ausgang verwendet.
Die Drosselrückschlagventile 37, 38, 39 und 40 lassen jeweils die Drosselung der Abluft einstellbar zu, wobei die Luft in Bewegungsrichtung ungehindert passieren kann.
Die Drosselrückschlagventile 37 und 40 sind dabei so eingestellt, daß mit einem sogenannten "Kriechgang" (extra langsam) des Kolbens immer die jeweils anzufahrende Endlage erreicht wird.
Mit Hilfe der Elektronik 34 ist es auch möglich eine Beeinflussung der Geschwindigkeit beim Anfahren des Kolbens zu erreichen. Die maximale Geschwindigkeit wird nur jeweils zwischen den zu durchfahrenden Positionen, an denen die Sensoren 22 und 31 angeordnet sind, erreicht. Das Hochfahren und das Abbremsen erfolgt in den Bereichen zwischen der Endlage 30 und dem Sensor 33 bzw. Sensor 32 und der Endlage 31 oder umgekehrt.
Mit dieser Lösung ist es mit einfachen Mitteln möglich, die Geschwindigkeit des Kolbens zu beeinflussen.

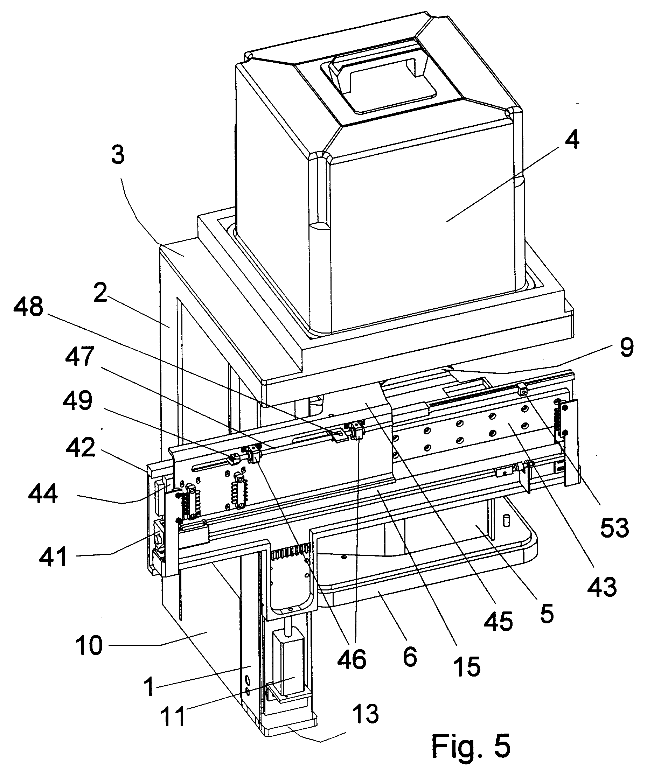

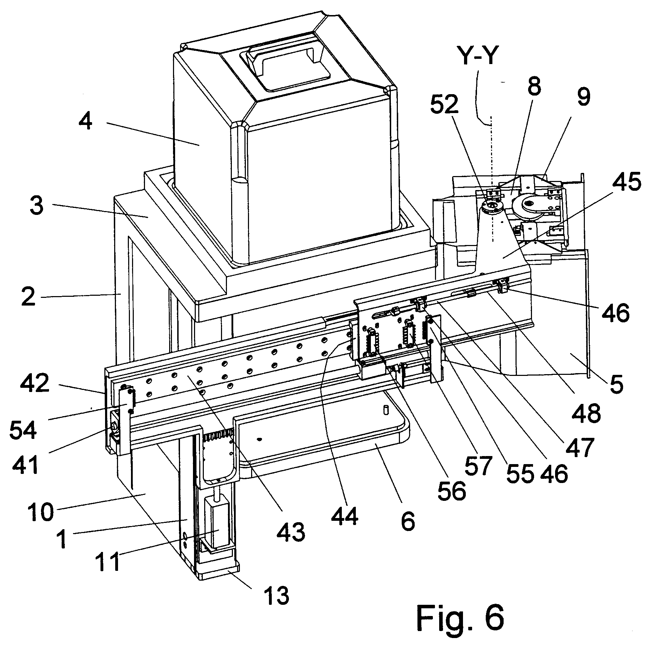

Das Ausführungsbeispiel nach den Figuren 5 und 6 verwendet zur Drehung des Magazins 8 um eine senkrecht zur Ebene der linearbewegung gerichteten Achse einen zum großen Teil gegenüber den Figuren 1 bis 3 konstruktiv verändert aufgebauten Linearantrieb 41. Da die gesamte Beschickungseinrichtung wie bereits beschrieben, modulartig aufgebaut ist, behalten unveränderte Bestandteile der Lösung ihre Bezugszeichen aus den Figuren 1 bis 3.

Der Linearantrieb 41, der ebenso wir der Linearantrieb 7 durch den Kurzhubzylinder 11 in einem Gleitlager höhenverstellbar ist, enthält auf einer Grundplatte 42 eine Führung 43 für einen Schlitten 44, an dem ein Greiferarm 45 befestigt ist. In seinem oberen Abschnitt weist der Greiferarm 45 eine durch Kugelumlaufführungen 46 geführte und gelagerte Zugstange 47 auf, an der, durch den Greiferarm 45 hindurchgeführt, ein Mitnehmer 48 und ein erster Anschlag 49 befestigt sind.
Der Mitnehmer 48 ist über eine Koppelstange 50 mit dem Greifer 8 verbunden. Zur Lagerung für die Koppelstange 50 dient eine außermittig angeordnete Kugelgelenkverbindung 51, die ein federkraftbeaufschlagtes, justierbares Anschlagsystem aufweist. Der Greifer 8 ist durch ein Greiferlager 52, dessen Drehachse Y-Y senkrecht zur Ebene der Linearbewegung gerichtet ist, am Greiferarm 45 drehbar gelagert.
Auf der Grundplatte 42 ist ein Zweiter Anschlag 53 so befestigt, daß bei vorwärtiger Linearbewegung des Greiferarms 45 in Richtung der Halbleiterbearbeitungsanlage der erste Anschlag 49 je nach seinem Ort der Befestigung auf der Zugstange 47 zur Anlage kommt. Dadurch bleibt die Zugstange 47 und damit der Mitnehmer 48 für die Koppelstange 50 bei weiterer Linearbewegung zurück und bewirkt eine rotatorische Bewegung der Greifers 8 um die Achse Y-Y der drehbaren Befestigung des Greifers 8 am Greiferam 45.
Durch Variation der Befestigung sowohl des ersten Anschlages 49 an der Zugstange 47 als auch des zweiten Anschlages 53 an der Grundplatte 42 ist der Ort des Drehbeginns und der Drehwinkel einstellbar. Auch mit der Änderung der Lage der Koppelstange 50 ist ein derartiger Effekt verbunden.

Eine Zugfeder 62 ist mit dem Mitnehmer 48 und über eine der Kugelumlaufführungen 46 an den Greiferarm 45 gekoppelt und dient bei dessen rückwärtiger Bewegung zur Einnahme der Ausgangslage für die Zugstange 47.

Zur Signal und Motorstromübertragung von der Versorgungseinheit 10 zu den Aktoren und Sensoren des Greifers 8 dienen Baugruppen 54, 55, 56, 57 mit federnden Kontakten 58, 59, 60, 61, die im Aufbau und in der Funktionsweise denen aus Fig. 1 bis 3 entsprechen.

Nicht dargestellt, jedoch ebenfalls in dieser Art und Weise aufgebaut und eine gleichartige Funktionsweise besitzend, sind auch am feststehenden und beweglichen Teil des Fahrstuhles derartige Baugruppen mit federnden Kontakten vorgesehen, mit denen eine Kontaktierung zwischen den Aktoren und Sensoren am beweglichen Teil und der Versorgungseinheit im feststehenden oder einer mit dem feststehenden Teil ebenfalls fest verbundenen Einheit ausschließlich in den Endlagen erfolgt.

Zur Verbindung der Beschickungseinrichtung mit einer Halbleiterbearbeitungsanlage oder einer beistellbaren Vorrichtung ist ein hier nicht näher beschriebenes mechanischen Interface vorgesehen.

Wie bereits in der DE-Patentschrift 43 26 309 C1 beschrieben, sind der Linearantrieb, der Fahrstuhlantrieb und der Antrieb für die greifenden Elemente des Greifers durch eine staubdichte Kapselung vom Reinstraum getrennt. An Öffnungen, durch die bewegte Objekte, wie der Greifer, seine greifenden Elemente und ein Element zur Aufnahme der Transportobjekte, das hier nicht näher beschrieben ist, in den Reinstraum ragen, grenzen Absaugeinrichtungen an.

## Patentansprüche

1. Einrichtung zur Umsetzung eines Transportobjektes zwischen zwei Endlagen, bei der ein feststehendes Teil ein zwischen den Endlagen durch einen Antrieb linear bewegliches Teil trägt, wobei das feststehende Teil eine Versorgungseinheit zur Signal- und Motorstromversorgung von Sensoren und Aktoren am beweglichen Teil enthält, dadurch gekennzeichnet, daß
zur Steuerung der Funktionen der Sensoren und Aktoren eine elektrische Kontaktierung der Sensoren und Aktoren mit der Versorgungseinheit (10) ausschließlich in den beiden Endlagen erfolgt.

2. Einrichtung nach Anspruch 1, dadurch gekennzeichnet, daß
zur elektrischen Kontaktierung Baugruppen (22, 23, 24, 54, 55, 56, 57) mit federnden Kontakten (25, 26, 27, 58, 59, 60, 61) vorgesehen sind, von denen das feststehende Teil in den Endlagen des beweglichen Teiles jeweils eine Baugruppe (22, 23, 54, 55) und das bewegliche Teil mindestens eine weitere Baugruppe (22, 23, 54, 55) trägt, wobei die federnden Kontakte (25, 26, 58, 59) am feststehenden Teil, die elektrisch mit der Versorgungseinheit (10) verbunden sind, den federnden Kontakten (27, 60, 61) am beweglichen Teil, von denen elektrische Verbindungen zu den Sensoren und Aktoren bestehen, zugewandt sind.

3. Einrichtung nach Anspruch 2, dadurch gekennzeichnet, daß
die federnden Kontakte (25, 26, 27, 58, 59, 60, 61) als Goldkontakte ausgebildet sind, in Form von federnd in einer Hülse gehaltenen Goldstiften.

4. Einrichtung nach einem der Ansprüche 1 bis 3, dadurch gekennzeichnet, daß die Sensoren und Aktoren in einer Platte (6) vorgesehen sind, die von einem beweglichen Teil eines Fahrstuhles aufgenommen ist und zur vertikalen Umsetzung des Transportobjektes von einer oberen Entnahme- und Rückführungsposition in eine untere Abstellposition dient.

5. Einrichtung nach einem der Ansprüche 1 bis 3, dadurch gekennzeichnet, daß die Sensoren und Aktoren Bestandteile eines Greifer (8) sind, mit dem die Umsetzung des Transportobjektes im wesentlichen horizontal erfolgt.

6. Einrichtung nach Anspruch 5, dadurch gekennzeichnet, daß zumindest in einem Abschnitt der Bewegung des beweglichen Teiles mit der Linearbewegung eine rotatorische Bewegung des Greifers (8) verbunden ist.

7. Einrichtung nach Anspruch 6, dadurch gekennzeichnet, daß
zwischen dem Greifer (8) und einem Greiferarm (17, 45), an dem der Greifer (8) drehbar befestigt ist und der die Verbindung zu dem Antrieb (7, 41) herstellt, eine mechanische Kopplung besteht, die die Linearbewegung des Greifers (8) mit der rotatorischen Bewegung des Greifers (8) verknüpft.

8. Einrichtung nach Anspruch 7, dadurch gekennzeichnet, daß
die drehbare Befestigung des Greifers (8) am Greiferarm (17) eine parallel zur Ebene der Linearbewegung und senkrecht zur Linearbewegung selbst gerichtete Drehachse (X-X) aufweist.

9. Einrichtung nach Anspruch 8, dadurch gekennzeichnet, daß
zur mechanischen Kopplung der rotatorischen Bewegung des Greifers (8) mit der Linearbewegung ein mit dem Greiferarm (17) verbundener erster Hebel (18) vorgesehen ist, der während der Linearbewegung eine Kulisse (19), die eine Höhendifferenz aufweist, abtastet, und der über eine drehbar befestigte Schubstange (20) mit einem am Greifer (8) befestigten zweiten Hebel (21) zur Übertragung der Höhendifferenz und Umformung in die rotatorische Bewegung verbunden ist.

10. Einrichtung nach Anspruch 9, dadurch gekennzeichnet, daß
der erste Hebel (18) zur Einstellung des Drehwinkels des Greifers (8) in seiner wirksamen Hebellänge einstellbar ist.

11. Einrichtung nach Anspruch 7, dadurch gekennzeichnet, daß
die drehbare Befestigung des Greifers (8) am Greiferarm (45) eine senkrecht zur Ebene der Linearbewegung gerichtete Drehachse (Y-Y) aufweist.

12. Einrichtung nach Anspruch 11, dadurch gekennzeichnet, daß
zur mechanischen Kopplung der rotatorischen Bewegung des Greifers (8) mit der Linearbewegung an einer, in Kugelumlaufführugen (46) geführten und gelagerten Zugstange (47) ein Mitnehmer (48) für eine am Greifer (8) in einer außermittig angeordneten Kugelgelenkverbindung (51) gelagerte Koppelstange (50) und ein erster Anschlag (49) befestigt sind, der bei vorwärtiger Linearbewegung des Greiferarms (45) durch seine Anlage an einem zweiten Anschlag (53) am festen Teil ein Zurückbleiben der Zugstange (47) und des Mitnehmers (48) verursacht.

13. Einrichtung nach Anspruch 12, dadurch gekennzeichnet, daß
die Kugelgelenkverbindung (51) ein federkraftbeaufschlagtes, justierbares Anschlagsystem aufweist.

14. Einrichtung nach einem der Ansprüch 5 bis 13, dadurch gekennzeichnet, daß für die Linearbewegung des Greifers (8) ein pneumatischer Linearantrieb (7, 41) vorgesehen ist.

15. Einrichtung nach Anspruch 14, dadurch gekennzeichnet, daß
zur Geschwindigkeitssteuerung für jede Richtung der Linearbewegung am Zylinder (15) des pneumatischen Linearantriebes (7, 41) mindestens ein Paar von parallel wirkenden Drosseln mit voneinander verschieden einstellbaren Luftdurchlaßmengen vorgesehen ist und die Zahl der in Richtung der Linearbewegung wirksam werdenden Drosseln in Abhängigkeit vom Ort des beweglichen Teiles und der Richtung der Linearbewegung von Sensorsignalen gesteuert ist.

16. Einrichtung nach Anspruch 15, dadurch gekennzeichnet, daß
als Drosseln Drosselrückschlagventile (37, 38, 39 und 40) vorgesehen sind, die die Drosselung von Abluft einstellbar zulassen und Luft in Bewegungsrichtung ungehindert durchlassen.
